# EUROPÄISCHE PATENTANMELDUNG

(11) **EP 2 602 662 A1**
(43) Veröffentlichungstag der Anmeldung: **12.06.2013**
(21) Anmeldenummer: 11192755.4
(22) Anmeldetag: 09.12.2011
(51) Int. Cl.: G03F 7/20, G03F 7/12, B41J 2/447

(54) **Beleuchtungssystem zur Herstellung von Drucksieben mit einem Richtstrahl-Kombinator**

(71) Anmelder: AKK GmbH, 47809 Krefeld (DE)
(72) Erfinder: Klenk, Dieter, 82110 Germering (DE)
(74) Vertreter: Cohausz & Florack

(57) **Zusammenfassung**

Die Erfindung betrifft eine Vorrichtung zur Belichtung von photoempfindlichem Material im ultravioletten Bereich, umfassend eine erste Leuchtdiode (2) zum Erzeugen einer ersten Strahlung mit einem ersten Wellenlängenspektrum im ultravioletten Bereich, eine zweite Strahlungsquelle (10) zum Erzeugen einer zweiten Strahlung mit einem zweiten Wellenlängenspektrum im ultravioletten Bereich, und Mittel (8) zum Kombinieren von mindestens zwei Strahlungen in eine gebündelte Strahlung, welche Mittel dazu eingerichtet sind, die erste Strahlung und die zweite Strahlung in eine dritte Strahlung mit einem dritten Wellenlängenspektrum im ultravioletten Bereich zu bündeln. Die Erfindung betrifft ferner ein entsprechendes Verfahren zur Belichtung von photoempfindlichem Material im ultravioletten Bereich.

## Beschreibung

Die vorliegende Erfindung betrifft eine Vorrichtung und ein Verfahren zur Belichtung von photoempfindlichem Material im ultravioletten Bereich.

In dem Zusammenhang der hier dargestellten technischen Lehre bedeutet "ultravioletter Bereich" im weiteren Sinne den Wellenlängenbereich des nahen Ultraviolett, auch Schwarzlicht genannt, sowie des angrenzenden Bereiches des sichtbaren Lichtes. Im engeren Sinne ist damit der Wellenlängenbereich elektromagnetischer Wellen zwischen 365 nm und 420 nm gemeint.

Aus dem Stand der Technik, etwa der Offenlegungsschrift EP 0 913 730 A1, ist ein Verfahren zum Herstellen von Flexodruckformen, Drucksieben und ähnlichen Erzeugnissen mit einer strukturierten Oberfläche bekannt, bei dem ein photoempfindliches Material wie beispielsweise ein Photopolymer flächig auf einen Träger aufgebracht wird. Das aufgetragene photoempfindliche Material wird gemäß einem vorgegebenen Muster in einzelnen Bereich bestrahlt, was zu einer Vernetzung des Materials in eben diesen bestrahlten Bereichen führt. Vorzugsweise findet diese Bestrahlung mit ultraviolettem Licht oder mit sichtbarem Licht in der Nähe des ultravioletten Lichtes statt. Die nicht bestrahlten und folglich nicht vernetzten Bereiche des photoempfindlichen Materials können anschließend ausgewaschen werden, wodurch eine durch das Muster der Bestrahlung vorgegebene Maske an vernetztem Material auf dem Träger zurückbleibt, welche dann sinnvoll weiterverarbeitet werden kann.

Herkömmlich wird das ultraviolette Licht für die beschriebene Bestrahlung mit Ultraviolett-Lampen erzeugt, wie etwa Xenon-Gasentladungslampen. Diese sind zwar in der Lage, die für die Belichtung erforderliche hohe Leuchtdichte zu liefern, verlieren aber mit zunehmender Betriebsdauer an Leuchtkraft, wodurch sie regelmäßig nachjustiert und entsprechend häufig vollkommen ausgetauscht werden müssen. Folglich sind auf solchen Lampen basierende Beleuchtungs- oder Bestrahlungssysteme wartungsaufwändig.

Prinzipiell ist das Erzeugen von ultraviolettem Licht auch durch geeignete Leuchtdioden möglich. Diese bieten einen günstigen Wirkungsgrad beim Erzeugen der Strahlung der gewünschten Wellenlänge und weisen eine lange Lebensdauer auf, über die zudem keinem oder nur eine geringe Abweichung der erzeugten Leuchtstärke stattfindet. Jedoch ist die von Leuchtdioden erreichbare Leuchtkraft im Vergleich zu der von Xenon-Gasentladungslampen begrenzt und häufig für den Zweck der Belichtung von photoempfindlichem Material unzureichend.

Die ebenfalls bekanten Laserdioden wiederum sind zwar leistungsstark, aber sehr teuer und ebenfalls sehr wartungsintensiv.

Vor diesem Stand der Technik bestand die Aufgabe der Erfindung darin, eine Vorrichtung und ein Verfahren zur Verfügung zu stellen, welches die Bestrahlung von photoempfindlichem Material mit ausreichender Leuchtkraft und geringem Wartungsaufwand ermöglicht.

In Bezug auf die Vorrichtung wird diese Aufgabe durch eine Vorrichtung zur Belichtung von photoempfindlichem Material im ultravioletten Bereich mit den Merkmalen des Patentanspruchs 1 gelöst.

In Bezug auf das Verfahren wird diese Aufgabe durch ein Verfahren zur Belichtung von photoempfindlichem Material im ultravioletten Bereich mit den Merkmalen des Patentanspruchs 9 gelöst.

Eine erfindungsgemäße Vorrichtung zur Belichtung von photoempfindlichem Material im ultravioletten Bereich umfasst eine erste Leuchtdiode zum Erzeugen einer ersten Strahlung mit einem ersten Wellenlängenspektrum im ultravioletten Bereich, eine zweite Strahlungsquelle zum Erzeugen einer zweiten Strahlung mit einem zweiten Wellenlängenspektrum im ultravioletten Bereich und Mittel zum Kombinieren von mindestens zwei Strahlungen in eine gebündelte Strahlung, welche Mittel dazu eingerichtet sind, die erste Strahlung und die zweite Strahlung in eine dritte Strahlung mit einem dritten Wellenlängenspektrum im ultravioletten Bereich zu bündeln.

Erfindungsgemäß wurde also erkannt, dass die Wirkung einer Leuchtdiode, welche für sich genommen möglicherweise keine ausreichende Leuchtkraft in dem gewünschten Wellenlängenbereich erzeugen kann, für die Bestrahlung von photoempfindlichem Material dadurch verbessert werden kann, dass die von ihr erzeugte Strahlung durch das Einkoppeln der Strahlung einer weiteren Strahlungsquelle verstärkt wird. Weil eine Leuchtdiode in einem verhältnismäßig schmalen Wellenlängenspektrum strahlt, kann dieses Einkoppeln durch eine Anordnung geschehen, welche bezogen auf unterschiedliche Wellenlängen ein anderes Brechungs-, Reflektions- oder sonstiges Umlenkungsverhalten aufweist. Das photoempfindliche Material wiederum weist regelmäßig seine charakteristische Lichtempfindlichkeit in einem Wellenlängenbereich auf, welcher breit genug ist um zu erlauben, dass die in ihrer Wellenlänge schmale Strahlung der Leuchtdiode mit einer Strahlung in anderen Wellenlängenbereichen, die aber dennoch das photoempfindliche Material ansprechen, kombiniert werden kann.

Die Mittel zum Kombinieren von mindestens zwei Strahlungen in eine gebündelte Strahlung sind dabei so eingerichtet, dass die mindestens zwei Strahlungen aus unterschiedlichen Richtungen auf das Mittel zum Kombinieren treffen, aber als einzelner gebündelter Strahl aus den Mitteln zum Kombinieren heraustreten. Es können also ohne weiteres auch mehr als zwei Strahlungen zu einer dritten Strahlung kombiniert werden.

Mit dem Wellenlängenspektrum einer Strahlung ist im Kontext der Erfindung die Menge der Wellenlängen gemeint, auf denen die jeweilige Strahlung Anteile aufweist und nicht der quantitative Verlauf der Strahlungsamplituden als Funktion der Wellenlänge.

Gebündelt bedeutet im Kontext der Erfindung, dass die Leuchtkraft des gebündelten Strahles wesentlich durch eine gewichtete Addition der Leuchtkraft der mindestens zwei kombinierten Strahlungen bestimmt wird, wobei der jeweilige Gewichtungsfaktor durch die Absorptions-, Brechungs- und Reflektionseigenschaften der Mittel zum Kombinieren für die betroffenen Wellenlängen bestimmt wird.

Die Mittel zum Kombinieren können entweder so angeordnet sein, dass die dritte Strahlung bereits parallel austritt. Ebenso kann die parallele Auslagerung der dritten Strahlung durch einen separaten und nachgelagerten Kollimator erzielt werden.

Die Mittel zum Kombinieren von mindestens zwei Strahlungen in eine gebündelte Strahlung können ein Prisma, ein Beugungsgitter oder ein Bragg-Gitter umfassen.

Ein erfindungsgemäßes Verfahren zur Belichtung von photoempfindlichem Material im ultravioletten Bereich umfasst die Schritte des Erzeugens einer ersten Strahlung mit einem ersten schmalbandigen Wellenlängenspektrum im ultravioletten Bereich, des Erzeugens einer zweiten Strahlung mit einem zweiten Wellenlängenspektrum im ultravioletten Bereich und des Kombinierens von mindestens der ersten Strahlung und der zweiten Strahlung in eine gebündelte Strahlung mit einem dritten Wellenlängenspektrum im ultravioletten Bereich.

Im Kontext der Erfindung hat ein schmalbandiges Wellenlängenspektrum eine Bandbreite von 20 nm oder weniger, vorzugsweise von 15 nm oder weniger.

In einer bevorzugten Ausführungsform der erfindungsgemäßen Vorrichtung umfassen die Mittel zum Kombinieren von mindestens zwei Strahlungen in eine gebündelte Strahlung einen Interferenzfilter.

In einer weiteren bevorzugten Ausführungsform der erfindungsgemäßen Vorrichtung ist der Interferenzfilter dazu eingerichtet, einfallende Strahlung mit einer Wellenlänge in dem ersten Wellenlängenspektrum zu reflektieren und einfallende Strahlung in dem zweiten Wellenlängenspektrum in dem zweiten Wellenlängenspektrum durchzulassen. Auf diese Weise kann erreicht werden, dass die reflektierte erste Strahlung und die durchgelassene zweite Strahlung in derselben Richtung und also überlagert aus dem Interferenzfilter austreten, obwohl sie jeweils aus einer anderen Richtung auf den Interferenzfilter auftreffen und folglich ihre jeweilige Quelle separat angeordnet ist.

In einer entsprechenden bevorzugten Ausführungsform des erfindungsgemäßen Verfahrens umfasst das Kombinieren von mindestens der ersten Strahlung und der zweiten Strahlung in eine gebündelte Strahlung das Reflektieren der ersten Strahlung durch einen Interferenzfilter und das Durchlassen der zweiten Strahlung durch den Interferenzfilter.

Gemäß einer weiteren bevorzugten Ausführungsform der Erfindung umfasst der Interferenzfilter einen dichroitischen Spiegel. Dichroitische Spiegel, welche auch als dielektrische Spigel bezeichnet werden, weisen ein sehr verlustarmes Reflektionsverhalten auf, wodurch die Leuchtkraft der gebündelten Strahlung einer Addition der jeweiligen Leuchtkraft der kombinierten Strahlungen möglichst nahe kommt. Insgesamt kann hiermit der Verlust an Leistung durch den Filter auf 10% begrenzt werden.

In noch einer weiteren bevorzugten Ausführungsform der Erfindung umfasst das dritte Wellenlängenspektrum die Wellenlängen des ersten Wellenlängenspektrums und die Wellenlängen des zweiten Wellenlängenspektrums.

In einer weiteren bevorzugten Ausführungsform der erfindungsgemäßen Vorrichtung umfasst die zweite Strahlungsquelle eine Leuchtdiode.

In einer bevorzugten Ausführungsform des erfindungsgemäßen Verfahrens ist das zweite Wellenlängenspektrum schmalbandig.

Eine möglichst vollständige Bündelung der jeweiligen Leuchtkraft der kombinierten Strahlungen ist dann möglich, wenn die Wellenlängen der jeweiligen Strahlungen sich in dem Bereich konzentrieren, in dem die Mittel zum Kombinieren das für die jeweilige Strahlung charakteristische Verhalten entsprechend einer Reflektion oder einem Durchlassen aufweisen. Folglich weist gemäß einer bevorzugten Ausführungsform der Erfindung der erste Wellenlängenabschnitt und der zweite Wellenlängenabschnitt jeweils eine Bandbreite von höchstens 20 nm, vorzugsweise von höchstens 15 nm auf.

Da die maximalen Empfindlichkeitswerte des photoempfindlichen Materials meist in einem verhältnismäßig engen Wellenlängenbereich erreicht werden, ist für einen hohen Wirkungsgrad ebenso erstrebenswert, dass beiden kombinierten Strahlungen relativ nahe an diesem Wellenlängenbereich liegen. Entsprechend weist in einer bevorzugten Ausführungsform der Erfindung der erste Wellenlängenabschnitt und der zweite Wellenlängenabschnitt einen Abstand von höchstens 20 nm auf. Grundsätzlich ist aber, insbesondere angepasst an die spektrale Empfindlichkeit des photoempfindlichen Materials, auch ein Abstand zwischen dem ersten Wellenlängenabschnitt und dem zweiten Wellenlängenabschnitt möglich, welcher größer als 20 nm ist. Eine untere Grenze für den Abstand ergibt sich in der Praxis aus dem Aufwand, der zur Ermöglichung kleiner Abstände bei dem Mittel zum Kombinieren von mindestens zwei Strahlungen getrieben werden muss.

In einer bevorzugten Ausführungsform des erfindungsgemäßen Verfahrens umfasst das Erzeugen der ersten Strahlung das Einstellen der Leuchtkraft der ersten Strahlung auf einen ersten Wert in Abhängigkeit von dem photoempfindlichen Material und das Erzeugen der zweiten Strahlung das Einstellen der Leuchtkraft der zweiten Strahlung auf einen zweiten Wert in Abhängigkeit von dem photoempfindlichen Material. Da die erste Strahlung und die zweite Strahlung jeweils ein verschiedenes Wellenlängenspektrum aufweisen, kann, je nach der Verteilung der Empfindlichkeit des photoempfindlichen Materials in Abhängigkeit der Wellenlänge, auch die relative Leuchtkraft der beiden Strahlungen dementsprechend eingestellt werden. Bei einer vorgegebenen Gesamtleuchtkraft kann etwa die Leuchtkraft derjenigen Strahlung, welche näher an einem Maximum der Lichtempfindlichkeit des zu bestrahlenden Materials liegt, höher gewählt werden als die Leuchtkraft der anderen Strahlung. So könnte etwa die erste Leuchtdiode zum Erzeugen der ersten Strahlung mit einer Leistung von 40 % ihrer maximal möglichen Leistung und die zweite Leuchtdiode zum Erzeugen der zweiten Strahlung mit einer Leistung von 90 % ihrer maximal möglichen Leistung betrieben werden.

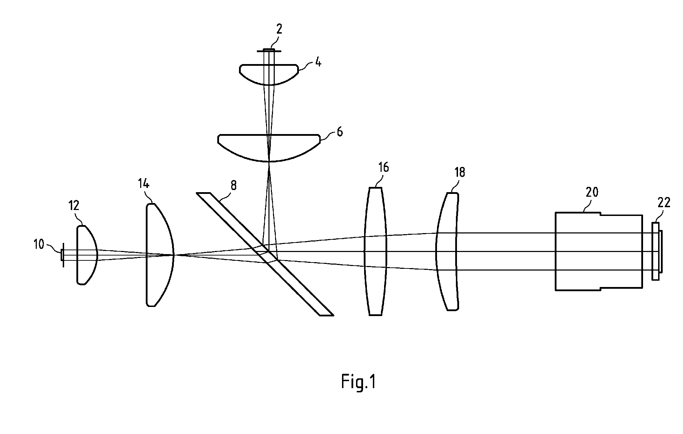

- Fig. 1: zeigt als einziges Ausführungsbeispiel ein erfindungsgemäßes Beleuchtungssystem.

Das in der Fig. 1 gezeigte Beleuchtungssystem ist Teil einer Anlage zum Herstellen von Drucksieben, Flexodruckformen oder ähnlichen flächigen Erzeugnissen mit einer durch Belichtung geschaffenen strukturierten Oberfläche. Der zu belichtende Träger mit dem auf ihm aufgetragenen photoempfindlichen Material ist in der Fig. 1 nicht dargestellt.

Das dargestellte Beleuchtungssystem umfasst eine erste Leuchtdiode 2, welche eine erste Strahlung erzeugt die effektiv nur aus einer Spektralkomponente mit einer Wellenlänge von 385 nm besteht. Diese Strahlung liegt zwar gerade noch im sichtbaren Bereich, ist aber noch zum ultravioletten Bereich im Sinne der Erfindung zu zählen.

Diese erste Strahlung tritt durch eine erste plan-konvexe Linse 4 und eine zweite plan-konvexe Linse 6 um dann auf einen dichroitischen Spiegel 8 in einem Winkel von annähernd 45° zu treffen.

Der dichroitische Spiegel 8 funktioniert nach dem Prinzip eines Interferenzfilters und ist dabei so beschaffen, dass er bei einer Grenzwellenlänge von 395 nm Licht mit einer unter dieser Grenze liegenden Wellenlänge reflektiert und andererseits Licht mit einer oberhalb dieser Grenze liegenden Wellenlänge durchlässt. Der dichroitische Spiegel weist dabei in dieser Filtereigenschaft eine so große Flankensteilheit auf, dass der Effekt bereits bei 10 nm Abstand von der Grenzwellenlänge nahezu vollständig eintritt. Folglich reflektiert er die erste Strahlung fast vollständig, wobei diese ihre Richtung verändert.

Das dargestellte Beleuchtungssystem umfasst ferner eine zweite Leuchtdiode 10, welche eine zweite Strahlung erzeugt die effektiv nur aus einer Spektralkomponente mit einer Wellenlänge von 405 nm besteht. Auch diese Strahlung ist noch zum ultravioletten Bereich im weiteren Sinne zu zählen.

Diese zweite Strahlung tritt durch eine dritte plan-konvexe Linse 12 und eine vierte plan-konvexe Linse 14 geführt um dann ebenfalls auf den dichroitischen Spiegel 8 in einem Winkel von annähernd 45° zu treffen, wenn auch auf einer anderen Seite des dichroitischen Spiegels 8 als die erste Strahlung. Entsprechend der bereits beschriebenen Eigenschaften des dichroitischen Spiegels 8 lässt dieser diese zweite Strahlung durch.

Die beiden Leuchtdioden 2 und 10 sowie die plan-konvexen Linsen 4, 6, 12, 14 und der dichroitische Spiegel 8 sind dabei so angeordnet, dass die reflektierte erste Strahlung und die durchgelassene zweite Strahlung zu einer gemeinsamen dritten Strahlung gebündelt werden, welche aus dem dichroitischen Spiegel 8 in einer anderen Richtung als der Einfallsrichtung einer der beiden ersten Strahlungen abgegeben wird. Der dichroitische Spiegel 8 stellt also ein Mittel zum Kombinieren von zwei Strahlungen in eine gebündelte Strahlung dar.

Diese dritte Strahlung, welche wesentlich aus der Spektralkomponente der ersten Strahlung bei der Wellenlänge von 385 nm und der Spektralkomponente der zweiten Strahlung bei der Wellenlänge von 405 nm besteht, tritt durch einen aus einer bi-konvexen Linse 16 und einer konvex-konkaven 18 Linse bestehenden Kollimator.

Die nach dem Durchgang durch die beiden Linsen 16 und 18 nunmehr parallele dritte Strahlung tritt danach in ein TIR (Total Internal Reflection - totale interne Reflektion) - Prisma 20 und weiter auf ein DMD 22 (Digital Micromirror Device - digitales Mikrospiegel Gerät), welches dann entsprechend der gewünschten Belichtung die dritte Strahlung reflektiert. Die somit nach einem vorgegebenen Muster reflektierte Strahlung trifft auf die mit photoempfindlichem Material bedeckte Oberfläche der herzustellenden Erzeugnisses und führt an den bestrahlten Abschnitten der Oberfläche zu einer Vernetzung des photoempfindlichen Materials. Nach der Belichtung kann das nicht vernetzte photoempfindliche Material abgewaschen werden und es verbleibt eine durch die Belichtung definierte Oberflächenstruktur, welche beispielsweise zu einer Flexodruckform weiterverarbeitet werden kann.

### Bezugszeichenliste

- 2: erste Leuchtdiode
- 4: erste plan-konvexe Linse
- 6: zweite plan-konvexe Linse
- 8: dichroitischer Spiegel
- 12: dritte plan-konvexe Linse
- 14: vierte plan-konvexe Linse
- 16: bi-konvexe Linse
- 18: konvex-konkave Linse
- 20: Totale interne Reflektion - Prisma
- 22: Digitales Mikrospiegel Gerät

## Patentansprüche

1. Vorrichtung zur Belichtung von photoempfindlichem Material im ultravioletten Bereich, umfassend:
- eine erste Leuchtdiode (2) zum Erzeugen einer ersten Strahlung mit einem ersten Wellenlängenspektrum im ultravioletten Bereich,
- eine zweite Strahlungsquelle (10) zum Erzeugen einer zweiten Strahlung mit einem zweiten Wellenlängenspektrum im ultravioletten Bereich, und
- Mittel (8) zum Kombinieren von mindestens zwei Strahlungen in eine gebündelte Strahlung, welche Mittel dazu eingerichtet sind, die erste Strahlung und die zweite Strahlung in eine dritte Strahlung mit einem dritten Wellenlängenspektrum im ultravioletten Bereich zu bündeln.

2. Vorrichtung nach Anspruch 1, wobei die Mittel zum Kombinieren von mindestens zwei Strahlungen in eine gebündelte Strahlung einen Interferenzfilter (8) umfassen.

3. Vorrichtung nach Anspruch 2, wobei der
Interferenzfilter (8) dazu eingerichtet ist, einfallende Strahlung mit einer Wellenlänge in dem ersten Wellenlängenspektrum zu reflektieren und einfallende Strahlung in dem zweiten Wellenlängenspektrum durchzulassen.

4. Vorrichtung nach Anspruch 2 oder 3, wobei der Interferenzfilter einen dichroitischen Spiegel (8) umfasst.

5. Vorrichtung zur Belichtung von photoempfindlichem Material nach einem der Ansprüche 1 bis 4, wobei das dritte Wellenlängenspektrum die Wellenlängen des ersten Wellenlängenspektrums und die Wellenlängen des zweiten Wellenlängenspektrums umfasst.

6. Vorrichtung nach einem der Ansprüche 1 bis 5, wobei die zweite Strahlungsquelle eine Leuchtdiode (10) umfasst.

7. Vorrichtung nach einem der Ansprüche 1 bis 6, wobei der erste Wellenlängenabschnitt und der zweite Wellenlängenabschnitt jeweils eine Bandbreite von höchstens 20 nm, vorzugsweise von höchstens 15nm aufweist.

8. Vorrichtung zur Belichtung von photoempfindlichem Material nach einem der Ansprüche 1 bis 7, wobei der erste Wellenlängenabschnitt und der zweite Wellenlängenabschnitt einen Abstand von höchstens 20 nm aufweisen.

9. Verfahren zur Belichtung von photoempfindlichem Material im ultravioletten Bereich, umfassend die Schritte:
- Erzeugen einer ersten Strahlung mit einem ersten schmalbandigen Wellenlängenspektrum im ultravioletten Bereich,
- Erzeugen einer zweiten Strahlung mit einem zweiten Wellenlängenspektrum im ultravioletten Bereich,
- Kombinieren von mindestens der ersten Strahlung und der zweiten Strahlung in eine gebündelte Strahlung mit einem dritten Wellenlängenspektrum im ultravioletten Bereich.

10. Verfahren nach Anspruch 9, wobei das Kombinieren von mindestens der ersten Strahlung und der zweiten Strahlung in eine gebündelte Strahlung das Reflektieren der ersten Strahlung durch einen Interferenzfilter (8) und das Durchlassen der zweiten Strahlung durch den Interferenzfilter (8) umfasst.

11. Verfahren nach Anspruch 10, wobei der Interferenzfilter einen dichroitischen Spiegel (8) umfasst.

12. Verfahren nach einem der Ansprüche 9 bis 11, wobei das zweite Wellenlängenspektrum schmalbandig ist.

13. Verfahren nach einem der Ansprüche 9 bis 12, wobei der erste Wellenlängenabschnitt und der zweite Wellenlängenabschnitt jeweils eine Bandbreite von höchstens 20 nm, vorzugsweise von höchstens 15 nm aufweisen.

14. Verfahren nach einem der Ansprüche 9 bis 13, wobei der erste Wellenlängenabschnitt und der zweite Wellenlängenabschnitt einen Abstand von höchstens 20 nm aufweisen.

15. Verfahren nach einem der Ansprüche 9 bis 14, wobei das dritte Wellenlängenspektrum die Wellenlängen des ersten Wellenlängenspektrums und die Wellenlängen des zweiten Wellenlängenspektrums umfasst.
